# FASCICULE DE BREVET EUROPEEN

(11) **EP 3 149 764 B1**
(45) Date de publication et mention de la délivrance du brevet: **13.02.2019**
(21) Numéro de dépôt: 15732320.5
(22) Date de dépôt: 21.05.2015
(51) Int. Cl.: H01L 21/027, H01L 21/768, H01L 21/311

(54) **PROCÉDÉ DE RÉALISATION DE MOTIFS PAR AUTO-ASSEMBLAGE DE COPOLYMERES A BLOCS**
MUSTERUNGSVERFAHREN MITTELS SELBSTANORDNUNG AUS BLOCKCOPOLYMEREN
PATTERNING METHOD USING SELF-ASSEMBLY OF BLOCK COPOLYMERS

(30) Priorité: 26.05.2014 FR 1454712
(43) Date de publication de la demande: 05.04.2017
(73) Titulaire: Commissariat à l'Énergie Atomique et aux Énergies Alternatives, 75015 Paris (FR)
(72) Inventeur: BELLEDENT, Jérôme, 38240 Meylan (FR); PIMENTA BARROS, Patricia, 38000 Grenoble (FR)
(74) Mandataire: Cabinet Camus Lebkiri
(86) Numéro de dépôt international: PCT/FR2015/051345
(87) Numéro de publication internationale: WO 2015/181474

(56) Documents cités:
- US-A1- 2009 200 646
- US-A1- 2014 091 476

## Description

### DOMAINE TECHNIQUE

La présente invention concerne les techniques d'assemblage dirigé de copolymères à blocs (« Directed Self-Assembly, DSA) afin de générer des motifs de très hautes résolution et densité. L'invention concerne plus particulièrement un procédé de réalisation de motifs à la surface d'un substrat, tels qu'un trou de contact ou une tranchée, en utilisant des copolymères à blocs.

### ETAT DE LA TECHNIQUE

Les besoins de procédés pour réaliser des motifs de dimensions nanométriques ont fortement augmenté ces dernières années, en raison de la tendance à la miniaturisation des composants électroniques.

Initialement, les motifs étaient réalisés par lithographie optique par projection. Dans ce procédé de réalisation, une couche photosensible est déposée sur un substrat, puis exposée à un faisceau ultraviolet à travers un masque définissant les motifs. La taille du plus petit motif réalisable (aussi appelée dimension critique « CD » pour « Critical Dimension » en anglais) est étroitement liée à la longueur d'onde du faisceau utilisé : plus la longueur d'onde est courte, plus le motif réalisé peut être fin et plus la densité d'intégration de ces motifs dans un circuit intégré peut être importante.

Les faisceaux ultraviolets utilisés en photolithographie ont classiquement une longueur d'onde de 193 nm ou 248 nm. Ce procédé de définition de motifs présente l'avantage d'être bien maitrisé et moins coûteux que d'autres procédés, notamment les procédés de lithographie électronique. Toutefois, avec de telles longueurs d'onde, la résolution de l'outil d'exposition est limitée.

Afin de réaliser des motifs plus fins, mieux résolus, et donc d'augmenter encore la densité d'intégration, de nouveaux procédés ont été développés, comme la photolithographie double exposition (« double-patterning »), la lithographie Extrême UltraViolet (EUV) et la lithographie par faisceau d'électrons (« e-beam »).

Parmi les technologies de lithographie émergentes, on peut également citer les techniques d'assemblage dirigé de copolymères à blocs (« Directed Self-Assembly, DSA). Les copolymères à blocs sont des polymères dans lesquels deux unités de répétition, un monomère A et un monomère B, forment des chaînes liées entre elles par une liaison covalente. Lorsque l'on donne suffisamment de mobilité aux chaînes, par exemple en chauffant ces copolymères à blocs, la chaîne A et la chaîne B ont tendance à se séparer en phases ou blocs et à se réorganiser sous des conformations spécifiques, qui dépendent notamment du ratio entre le monomère A et le monomère B. En fonction de ce ratio, on peut par exemple avoir des sphères du monomère A dans une matrice du monomère B, ou bien des cylindres de A dans une matrice de B, ou encore des lamelles de A et des lamelles de B intercalées. Les copolymères à blocs ont donc la propriété de former des motifs qui peuvent être contrôlés grâce au ratio de monomères. Puis, en retirant sélectivement l'une des deux phases du copolymère (par exemple les cylindres de A), ces motifs de monomère peuvent être transformés en cavités.

Les techniques connues d'auto-assemblage de copolymères à blocs peuvent être regroupées en deux catégories, la grapho-épitaxie et la chémi-épitaxie, toutes deux décrites en détail dans l'article ["Guided self-assembly of block-copolymer for CMOS technology: a comparative study between grapho-epitaxy and surface chemical modification", L. Oria et al., SPIE 2011, Vol. 7970-24].

La grapho-épitaxie consiste à former des motifs primaires appelés guides à la surface d'un substrat, ces guides délimitant des zones à l'intérieur desquelles une couche de copolymère à blocs est déposée. Les guides permettent de contrôler l'organisation des blocs de copolymère pour former des motifs secondaires de plus haute résolution à l'intérieur de ces zones. Alternativement, la chémi-épitaxie consiste à modifier les propriétés chimiques de certaines portions du substrat, pour forcer l'organisation des blocs de copolymère entre ces portions. Comme les guides formés en grapho-épitaxie, ces portions du substrat modifiées chimiquement sont délimitées par une étape de photolithographie classique.

Compte tenu de leur résolution élevée, les techniques DSA ont été récemment utilisées pour former les trous de contacts d'un circuit intégré. Ces contacts, appelés également vias, permettent de connecter électriquement deux niveaux d'interconnexion superposés dans un circuit intégré. Or, avec la miniaturisation des composants, les vias sont de plus en plus nombreux et rapprochés.

Le document US2014/091476 divulgue un procédé d'auto-assemblage de copolymère à blocs pour former des trous de contact dans une couche diélectrique contenant des lignes d'interconnexion inférieures. Ces trous de contact sont « auto-alignés » avec des lignes d'interconnexion supérieures, grâce au fait que le masque dur servant à délimiter les lignes d'interconnexion supérieures constitue également le guide d'assemblage du copolymère à blocs. Les trous de contact sont obtenus en assemblant le copolymère à blocs déposé dans le masque, puis en gravant certains des blocs du copolymère au travers d'un masque en résine photosensible.

De façon similaire, dans l'article intitulé « Contact Hole Patterning for Random Logic Circuits using Block Copolymer Directed Seld-Assembly » (Alternative Lithography Technologies IV, Proc. of SPIE, Vol. 8323, 2012), un procédé de grapho-épitaxie est utilisé pour imprimer les vias. Une photolithographie est mise en oeuvre pour définir les guides d'assemblage d'un copolymère à blocs. Les guides sont élaborés de sorte que les cavités formées à l'aide du copolymère à blocs correspondent au dessin des vias.

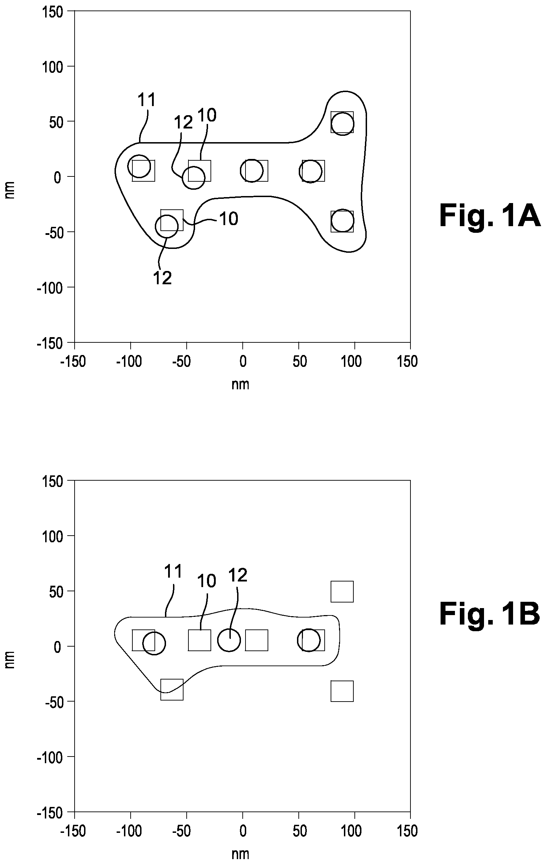

Sur la figure 1A est représenté un exemple de plusieurs contacts 10 à former et le guide d'assemblage 11 correspondant. On constate que dans cet exemple les cavités 12 issus de l'assemblage de copolymère correspondent relativement bien au dessin des contacts 10 à réaliser. Par contre, sur la figure 1B obtenue en utilisant le même procédé, mais avec un léger décalage de paramètres (lié aux variations naturelles du procédé), en l'occurrence un défocus de 60 nm, on obtient des cavités 12 qui ne correspondent plus aux contacts 10 attendus. Cela est dû au fait que le guide 11 n'est pas suffisamment défini, car la résolution de l'outil de photolithographie ayant formé le guide n'est pas suffisante.

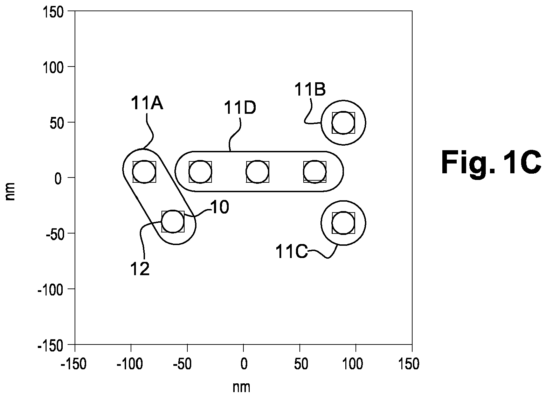

Pour éviter ce problème, l'article susmentionné propose d'utiliser des formes de guide simplifiées, de type tranchée rectiligne, avec au maximum trois cavités 12 par guide. Il s'en suit, que pour imprimer l'ensemble des vias par grapho-épitaxie entre deux niveaux de métal d'un circuit intégré, plusieurs étapes d'impression avec auto-assemblage sont nécessaires. Par exemple, sur la figure 1C, les guides 11A, 11B et 11C seront formés lors d'une première passe (car ils sont suffisamment éloignés les uns des autres pour ne pas être confondus lors de l'étape de photolithographie), et le guide restant 11D est formé lors d'une seconde passe (autrement dit, par un niveau supplémentaire).

En plus du fait qu'un tel procédé est long et coûteux, il existe des problèmes d'alignement entre les motifs provenant de différentes expositions. On obtient en effet plusieurs populations statistiques de contacts.

### RESUME DE L'INVENTION

On constate qu'il existe un besoin de prévoir un procédé de réalisation de motifs à la surface d'un substrat par auto-assemblage de copolymères à blocs, et notamment de copolymères à blocs cylindriques, qui permette d'exposer un niveau de contacts en moins d'étapes d'exposition, et avantageusement en une seule fois, tout en conservant une grande liberté dans le positionnement de ces contacts.

Selon l'invention, on tend à satisfaire ce besoin en prévoyant les étapes suivantes :
- former à la surface du substrat un premier masque comportant des évidements, les évidements du masque délimitant à la surface du substrat des zones à métalliser ;
- former un guide d'assemblage au-dessus du premier masque, de sorte que le guide d'assemblage délimite une surface couvrant deux zones de contact et une portion pleine du premier masque disposée entre les deux zones de contact, les deux zones de contact appartenant respectivement à deux zones à métalliser ;
- déposer sur ladite surface une couche de copolymère à blocs ;
- réorganiser la couche de copolymère à blocs ;
- éliminer une des phases de la couche de copolymère à blocs réorganisée, d'où il résulte une pluralité de trous s'étendant dans la couche de copolymère à blocs au-dessus des deux zones de contact et de ladite portion pleine du premier masque ;
- élargir par gravure les trous de la couche de copolymère à blocs, jusqu'à former une tranchée continue au-dessus des deux zones de contact et de ladite portion pleine du premier masque ;
- transférer à la surface du substrat, au travers des évidements du premier masque, des première et deuxième parties de la tranchée continue situées au-dessus des deux zones de contact, d'où il résulte lesdits motifs, ladite portion pleine du premier masque empêchant le transfert à la surface du substrat d'une troisième partie de la tranchée continue située au-dessus de ladite portion pleine du premier masque.

Dans un mode de mise en oeuvre préférentiel, le procédé comprend en outre les étapes suivantes :
- déposer une couche de planarisation sur le premier masque et au moins une couche destinée à former un deuxième masque sur la couche de planarisation, le guide d'assemblage et la couche de copolymère à blocs étant formés sur ladite couche destinée à former le deuxième masque ;
- former simultanément la tranchée continue dans la couche de copolymère à blocs et dans le deuxième masque ; et
- transférer la tranchée continue du deuxième masque dans la couche de planarisation jusqu'au premier masque.

De préférence, le deuxième masque est formé d'un empilement comprenant une couche de nitrure et une couche d'oxyde.

Selon un développement, la formation de la tranchée dans le deuxième masque comprend successivement une étape de gravure anisotrope de la couche de nitrure à travers la couche de copolymère à blocs, une étape de gravure isotrope de la couche de nitrure, une étape de gravure anisotrope de la couche d'oxyde à travers la couche de nitrure et une étape de gravure isotrope de la couche d'oxyde.

L'élargissement des trous de la couche de copolymère à blocs se produit avantageusement lors des étapes de gravure isotrope de la couche de nitrure et de la couche d'oxyde.

Le procédé selon l'invention peut également présenter une ou plusieurs des caractéristiques ci-dessous, considérées individuellement ou selon toutes les combinaisons techniquement possibles :
- le guide d'assemblage est rectiligne et arrangé de sorte que les deux zones de contact occupent des extrémités de la surface délimitée par le guide d'assemblage ;
- le guide d'assemblage est formé par grapho-épitaxie et le procédé comprend une étape de dépôt d'une couche de greffage sur des parois latérales et au fond du guide d'assemblage ;
- le copolymère à blocs contient du polystyrène et du polyméthacrylate de méthyle et la couche de greffage est à base d'homo-polystyrène ;
- le procédé comprend une étape de gravure de la couche de greffage par un plasma contenant du dioxygène, immédiatement après l'élimination d'une des phases de la couche de copolymère à blocs réorganisée ;
- le substrat comporte un niveau de connexion électrique et une couche en un matériau diélectrique recouvrant le niveau de connexion électrique et dans laquelle sont formés lesdits motifs ; et
- les motifs à la surface du substrat sont des trous d'interconnexion traversant la couche en matériau diélectrique jusqu'au niveau de connexion électrique.

### BREVES DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A, 1B et 1C représentent des trous de contact formés par un procédé d'auto-assemblage de copolymères à blocs selon l'art antérieur, en utilisant un ou plusieurs niveaux d'assemblage de copolymère à blocs ;
- la figure 2 est un schéma de principe d'un procédé de réalisation de motifs par auto-assemblage de copolymères à blocs selon l'invention ;
- les figures 3A à 3K représentent, en vue de coupe selon l'axe A-A de la figure 2, des étapes d'un procédé de réalisation de motifs selon un mode de mise en oeuvre préférentiel de l'invention ;
- les figures 4C, 4F, 4G, 4H, 4I, 4J et 4K sont des vues de dessus du substrat lors des étapes des figures 3C, 3F, 3G, 3H, 3I, 3J et 3K ; et
- les figures 5H à 5L représentent, en vue de coupe selon l'axe B-B de la figure 2, les étapes du procédé de réalisation de motifs correspondant aux figures 3H à 3K.

Pour plus de clarté, les éléments identiques ou similaires sont repérés par des signes de références identiques sur l'ensemble des figures.

### DESCRIPTION DETAILLEE D'AU MOINS UN MODE DE REALISATION

On décrit ci-après un procédé d'assemblage dirigé de copolymères à blocs (DSA) permettant d'imprimer, en une seule fois, une grande densité de motifs à la surface d'un substrat. Ce procédé est avantageusement utilisé pour former les trous de contact d'un circuit intégré à partir de copolymères à blocs cylindriques.

Le procédé s'applique plus particulièrement aux contacts qui sont éloignés entre eux d'une distance inférieure au pas minimum de résolution par photolithographie. Par exemple, avec un outil de photolithographie à immersion de longueur d'onde égale à 193 nm, le pas minimum entre deux motifs est d'environ 88 nm. Par conséquent, tous les contacts ayant un voisin éloigné de moins de 88 nm vont être regroupés afin d'être imprimés dans le même guide.

Ce procédé peut également s'appliquer aux trous de contact ne disposant pas de voisin immédiat, mais dont les dimensions sont telles qu'ils ne peuvent pas être résolus par photolithographie ou encore afin d'améliorer le contrôle dimensionnel de ces trous.

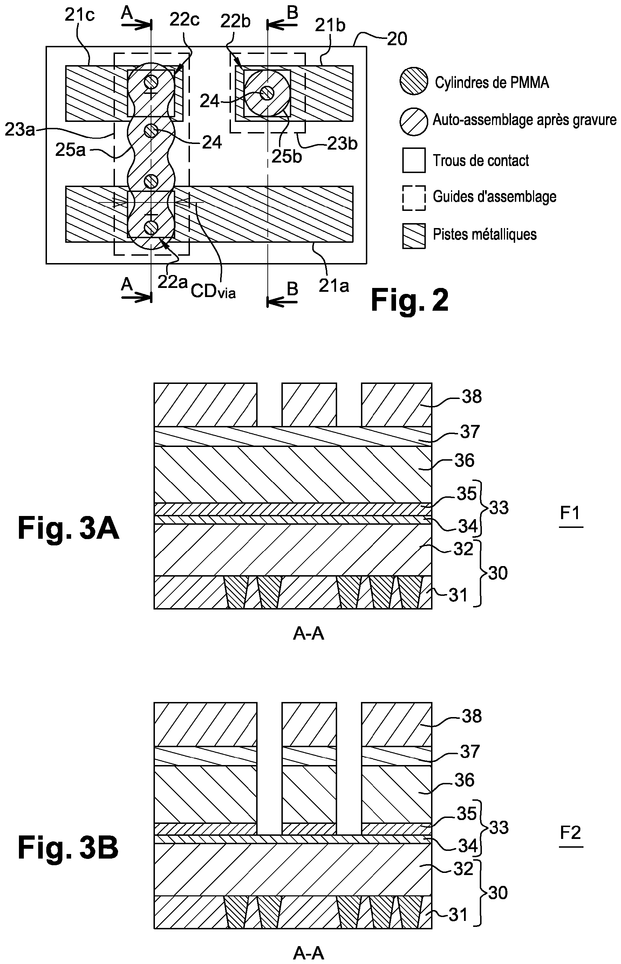

La figure 2 est un schéma de principe du procédé expliquant, dans l'une et l'autre de ces situations, de quelle manière on peut former des trous de contact en bon nombre et aux bons emplacements dans un substrat. Dans cet exemple représenté en vue de dessus, on vise à former un niveau d'interconnexion comprenant trois pistes métalliques, et trois contacts verticaux ou « vias » qui connectent les pistes métalliques à un niveau de métal inférieur (non représenté), c'est-à-dire situé en dessous des pistes métalliques.

Dans ce procédé, les pistes métalliques et les vias sont délimités à l'aide d'un masque 20. Le masque 20 comporte des évidements 21a à 21c correspondant aux futures pistes métalliques. Autrement dit, le masque délimite des zones 21a-c du substrat à métalliser pour former les pistes. A l'intérieur des zones à métalliser 21a-c apparaissent des zones de contact 22a à 22c, représentées par des carrés en trait plein. Elles définissent l'emplacement des trous de contact, pour former les vias.

Les deux zones de contact 22a et 22c, situées à gauche sur la figure 2 et appartenant respectivement aux zones à métalliser 21a et 21c, sont trop proches l'une de l'autre pour pouvoir être imprimées de façon classique par photolithographie. La troisième zone de contact 22b, située à droite et appartenant à la zone à métalliser 21b, correspond au cas d'un contact isolé dont on souhaite contrôler précisément le dimensionnement. Ainsi, pour définir ces zones de contact 22a à 22c, un copolymère à blocs va être utilisé.

Des guides d'assemblage du copolymère à blocs sont tout d'abord formés sur le masque 20, de préférence par grapho-épitaxie. Les zones de contact 22a et 22c sont regroupées au sein d'un même guide d'assemblage 23a. Le guide 23a délimite ainsi une surface couvrant les zones de contact 22a et 22c, mais également une portion du masque 20 disposée entre ces deux zones. La zone de contact 22b dispose de son propre guide 23b.

Les guides 23a et 23b peuvent être formés par photolithographie (à 193 nm par exemple), compte tenu qu'ils ont des dimensions supérieures à la dimension critique (i.e. dimension du petit motif) atteignable par photolithographie.

Puis, une couche de copolymère à blocs, par exemple du polystyrène-b-polyméthacrylate de méthyle (PS-b-PMMA), est déposée dans les guides 23a et 23b. Les blocs de polystyrène et les blocs de PMMA sont ensuite réorganisés. On obtient, dans l'exemple de la figure 2, quatre cylindres 24 de PMMA dans le guide 23a et un seul cylindre 24 de PMMA dans le guide 23b, le ou les cylindres dans chaque guide étant entourés d'une matrice de polystyrène.

Dans le guide rectiligne 23a, les cylindres 24 de PMMA se répartissent le long d'une ligne A-A située au centre du guide et orientée dans le sens de la longueur du guide. Dans le guide 23b en forme de carré, l'unique cylindre 24 de PMMA occupe la zone centrale du carré.

Le procédé comporte ensuite une étape d'élimination d'une des phases de la couche de copolymère à blocs réorganisés, la phase de PMMA dans l'exemple précédent. Les cylindres 24 de PMMA sont ainsi gravés pour former une pluralité de trous dans le guide 23a (4 trous dans l'exemple de la figure 2) et un seul trou dans le guide 23b.

Comme cela est visible sur la figure 2, les trous cylindriques 24 formés par gravure du PMMA ont des dimensions bien inférieures aux zones de contact 22a-c, c'est-à-dire aux vias que l'on souhaite former. Ceci n'est pas problématique, dans la mesure où ils sont ensuite élargis par gravure de la matrice de polystyrène. En effet, la dimension critique obtenue grâce à l'utilisation du copolymère à blocs est certes largement inférieure à celle atteignable par photolithographie à 193 nm (CD_{DSA} ≈ 15-20 nm et CDₚₕₒₜₒ ≈ 55 nm), mais aussi inférieure à celle souhaitée pour les via (typiquement CDᵥᵢₐ ≈ 48 nm). En d'autres termes, le copolymère à blocs est tellement résolvant qu'il est nécessaire d'élargir les trous formés par la gravure du PMMA pour atteindre la dimension critique voulue.

Dans le guide 23a, les trous 24 sont élargis par gravure du bloc de polystyrène, jusqu'à ce que les trous fusionnent en une tranchée continue 25a qui recouvre les zones de contact 22a, 22c en quasi-totalité et la portion du masque 20 disposée entre les zones de contact 22a et 22c. De la même manière, le trou 24 du guide 23b occupe, après gravure du polystyrène (trou élargi 25b), sensiblement la même surface que celle prévue par le dessin du via (zone de contact 22b).

Enfin, lors d'une dernière étape du procédé, la tranchée 25a est transférée dans le substrat sur lequel repose le masque 20, et plus particulièrement dans une couche diélectrique destinée à séparer les deux niveaux d'interconnexion consécutifs. Ici, seules les parties de la tranchée 25a recouvrant les zones à métalliser 21a et 21c sont transférées dans la couche diélectrique, car en dehors de ces zones, le masque 20 bloque la gravure de la couche diélectrique. Plus particulièrement, sous la portion du masque 20 disposée entre les deux zones de contact 22a et 22c, la couche diélectrique sous-jacente n'est pas gravée, de sorte qu'on obtient deux trous de contact distincts dans la couche diélectrique. Les trous de contact ainsi formés sont aux emplacements et dimensions prévues par le dessin des zones de contact 22a et 22c. Ces trous de contact pourront être ensuite remplis de métal pour former les vias et connecter les deux niveaux d'interconnexion.

Les trous de contact à la surface du substrat résultent donc de la superposition du masque 20 définissant les pistes métalliques et de l'assemblage de copolymère délimitant la tranchée 25a. Les zones de contact 22a et 22c peuvent être très proches l'une de l'autre, tant qu'une portion de masque 20 les sépare. Le pas des motifs à imprimer est par conséquent contrôlé par le masque 20 des pistes métalliques.

Grâce à ce procédé, les cylindres 24 de PMMA situés aux extrémités du guide 23a n'ont pas besoin d'être parfaitement centrés par rapport aux zones de contact 22a et 22c, dans une direction au moins. En l'occurrence, ils peuvent être légèrement décalés par rapport à la ligne médiane des zones à contacter 21a et 21c (cf. Fig.2), dans la mesure où l'élargissement et la fusion des trous cylindriques va compenser ce décalage. Cela permet de relâcher partiellement (dans une direction seulement) les contraintes sur le placement des guides d'assemblage, et notamment de former des guides d'assemblage compatibles avec la résolution des équipements de photolithographie. Par contre, dans la direction perpendiculaire (dans l'axe du guide rectiligne 23a), les cylindres 24 sont avantageusement alignés avec la droite A-A reliant les centres des zones de contact 22a et 22b. Ce contrôle est cependant facile à réaliser, de par la forme rectiligne du guide et de l'espacement latéral important entre deux guides consécutifs (supérieur au pas minimal de résolution par photolithographie).

Par ailleurs, le fait de pouvoir disposer de moins d'expositions par rapport à l'art antérieur, voire d'une seule exposition, permet de diminuer le nombre de populations statistiques de vias, permettant ainsi un meilleur contrôle de l'alignement.

On remarque également que la position des cylindres centraux, i.e. au-dessus du masque 20, importe peu dans ce procédé. La portion correspondante de la tranchée 25a peut avoir une forme quelconque, puisqu'elle ne sera pas transférée dans le diélectrique.

A l'inverse, la position des cylindres de PMMA au-dessus des zones de contact 22a et 22c est plus délicate, comme cela a été décrit plus haut. Le guide d'assemblage 23a est, de préférence, agencé pour que les zones de contact 22a et 22c occupent les extrémités du guide. Ainsi, les cylindres 24 de PMMA aux extrémités du guide coïncident sensiblement avec les zones de contact 22a et 22c (les cylindres aux extrémités sont en général moins sujet aux variations de positionnement que les cylindres au centre du guide).

De façon similaire, le trou élargi 25b du guide 23b est transféré dans la couche diélectrique à travers la zone à métalliser 21b du masque 20, formant ainsi un trou de contact parfaitement positionné et aux bonnes dimensions par rapport à la zone de contact 22b.

L'utilisation d'un copolymère à blocs permet d'obtenir une dimension critique CDᵥᵢₐ inférieure à celle atteignable par les techniques classiques de photolithographie. En outre, dans l'hypothèse où deux guides d'assemblage adjacents fusionneraient lors de l'étape de photolithographie, la position des cylindres à l'intérieur des guides fusionnés serait pratiquement inchangée par rapport à celle où les guides sont distincts. Il n'y aurait donc pas de cylindre de PMMA indésirable dans la zone de jonction des deux guides.

Le fait de former des cylindres de PMMA entre deux guides peut être problématique, si au même endroit il est également prévu de former une piste métallique. En effet, dans cas, le cylindre surplombe un évidement du masque 20 et sera transféré dans la couche diélectrique, formant un trou de contact jusqu'au niveau d'interconnexion inférieur (plutôt qu'une simple tranchée pour recevoir ladite piste métallique). Par conséquent, l'utilisation de copolymère à blocs permet aussi de relâcher les contraintes sur le placement des guides, en évitant de former un trou de contact indésirable (les guides peuvent être, dans une direction, proches les uns des autres).

Deux guides d'assemblage sont susceptibles de fusionner (par exemple le guide rectiligne 23a de la figure 2 et un autre guide rectiligne de même orientation situé dans le prolongement du guide 23a), car leurs dimensions peuvent varier (à cause notamment des variations des paramètres du procédé de photolithographie : dose d'exposition, dimensions des masques, distance de focalisation...). Les copolymères à blocs ont donc la particularité de compenser les variations dimensionnelles des guides.

A titre d'exemple, pour un guide de dimension critique « cible » (i.e. souhaitée) comprise entre 45 nm et 55 nm, l'erreur maximale commise sur cette dimension (due aux variabilités du procédé de photolithographie) est de l'ordre de 10 nm, alors que l'erreur maximale sur la dimension critique des cylindres de PMMA formés dans ces guides n'est que de 2 nm. Le contrôle dimensionnel des motifs est donc amélioré grâce à l'utilisation des copolymères à blocs (ici d'un facteur 5).

Les guides d'assemblage 23a et 23b ont, de préférence, une dimension critique comprise entre 45 nm et 55 nm, car dans cette gamme, le taux de remplissage des cylindres dans les guides est maximal (autrement dit, les cylindres de PMMA sont tous formés).

Comme indiqué précédemment, deux contacts voisins séparés d'une portion du masque 20 sont groupés au sein d'un même guide et imprimés ensemble à l'aide de ce procédé DSA. Du point de vue du dessin des contacts (« layout »), cela revient à grouper deux contacts lorsque le segment reliant les centres de ces contacts croise exactement deux bords de pistes métalliques (par exemple sur la figure 2, le segment reliant les centres des zones 22a et 22c intercepte le bord supérieur de la zone/piste 21a et le bord inférieur de la zone/piste 21c).

Alternativement, deux contacts peuvent être groupés ensemble même s'ils appartiennent à la même zone à métalliser (et qu'ils ne sont donc pas séparés par une portion de masque 20), à condition que les futurs trous de contact débouchent sur la même ligne de métal du niveau d'interconnexion inférieur. Dans le cas contraire, un court-circuit des deux lignes de métal du niveau inférieur serait provoqué, car l'ensemble de la tranchée reliant les deux contacts est dans ce cas transférée au travers du masque 20.

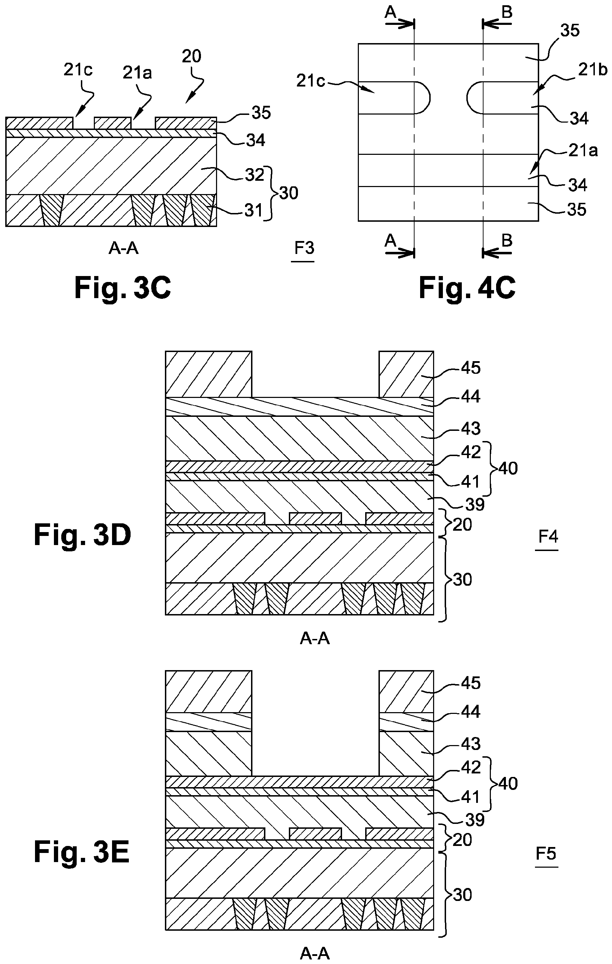

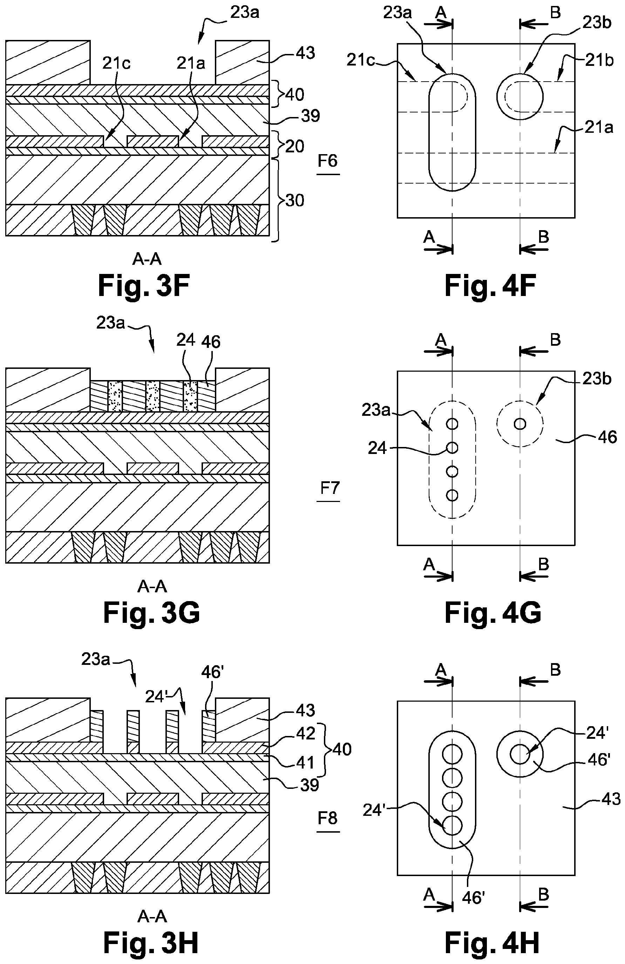

Un mode de mise en oeuvre préférentiel du procédé de réalisation de motifs selon l'invention va maintenant être décrit en détail, en relation avec les figures 3A à 3K. Ces figures représentent en vue de coupe selon A-A (Fig.2) des étapes F1 à F11 pour former des trous de contact entre deux niveaux d'interconnexion dans un circuit intégré. Les figures 4C, 4F à 4K sont des vues de dessus du substrat prises respectivement lors des étapes des figures 3C, 3F à 3K.

Les étapes F1 à F3 (Figs.3A-3C et 4C) permettent la formation du masque 20 à la surface d'un substrat 30. Le substrat 30 comporte un premier niveau d'interconnexion électrique 31 recouvert d'une couche diélectrique 32, par exemple en oxyde de silicium.

A l'étape F1 de la figure 3A, un empilement bi-couche 33 destiné à former le masque 20 est déposé sur la surface du substrat 30. L'empilement 33 comporte avantageusement une couche d'oxyde 34 (par exemple de l'oxyde de silicium de 40nm d'épaisseur), en contact avec la couche diélectrique 32, et une couche de nitrure 35, par exemple en nitrure de titane TiN de 15 nm d'épaisseur, disposée sur la couche d'oxyde 34. Puis, l'empilement 33 est recouvert d'une couche de planarisation 36 en un matériau organique (OPL, « Organic Planarisation Layer ») et d'une couche anti-réflective 37 (ARC pour « Anti Reflective Coating » en anglais).

Une couche de résine 38 est ensuite déposée sur la couche anti-réflective 37, puis structurée, de préférence par une photolithographie à impression double (« double-patterning »). Les couches 36 et 37 permettent d'absorber les ondes lumineuses réfléchies par le substrat lors des étapes d'exposition, évitant la création d'ondes stationnaires et améliorant ainsi le contrôle dimensionnel. Les motifs formés dans la résine correspondent au dessin des zones à métalliser 21a à 21c pour former le niveau d'interconnexion supérieur.

En F2 (Fig.3B), les motifs en résine sont transférés dans la couche anti-réflective 37, la couche de planarisation 36 et la couche de nitrure 35. Ce transfert peut être réalisé par des étapes de gravure successives, de type plasma. La couche ARC 37 est gravée sélectivement au travers de la résine 38, puis joue le rôle de masque dur pour la gravure de la couche OPL 36, cette dernière servant à son tour de masque pour graver la couche de TiN 35. La couche d'oxyde 34 sert avantageusement de couche d'arrêt de la gravure du TiN.

Après enlèvement des couches 36 à 38 à l'étape F3 des figures 3C et 4C, on obtient le masque 20 et ses évidements 21a-21c (i.e. les zones à métalliser 21a-21c) qui serviront à former les pistes métalliques.

A l'étape F4 (Fig.3D), on dépose sur le substrat 30 recouvert du masque 20 les couches qui serviront à former les guides d'assemblage 23a et 23b de la figure 2. Une autre couche de planarisation 39, de préférence en matériau organique, est ainsi déposée sur le premier masque 20, puis un deuxième niveau de masquage 40 est formé sur la couche de planarisation 39. Comme le premier masque 20, le deuxième niveau de masquage 40 comporte avantageusement une couche d'oxyde 41 (par exemple un oxyde TEOS) et une couche de nitrure 42 (par exemple TiN). Enfin, le deuxième niveau de masquage 40 est successivement recouvert d'une couche OPL 43, d'une couche ARC 44 et d'une couche de résine 45.

Dans ce mode de mise en oeuvre préférentiel, les guides d'assemblage sont formés par photolithographie optique et gravure de la couche de planarisation 43 déposée sur le deuxième niveau de masquage 40. La résine 45 est exposée au travers d'un masque amovible (non représenté) puis développée (Fig.3D) et, en F5 (Fig.3E), les couches ARC 44 et OPL 43 sont gravées de façon anisotrope (par exemple par plasma) à travers la couche de résine 45 développée.

Comme précédemment, les épaisseurs et les indices optiques des couches OPL 43 et ARC 44 sont choisis pour minimiser la réflexion de lumière à la longueur d'onde d'exposition de l'outil de photolithographie. Les guides d'assemblage ont alors une meilleure résolution.

A l'étape F6 des figures 3F (vue de coupe selon A-A) et 4F (vue de dessus), la couche de résine 45 est retirée (étape de « stripping ») et la couche ARC 44 est supprimée, par exemple au moyen d'une gravure fluorée. La gravure fluorée modifie l'état de surface des guides 23a et 23b formés dans la couche OPL 43, en formant sur la surface des guides des groupes fluorés qui empêcheront la couche de copolymère d'y adhérer. Pour y remédier, une couche de greffage peut être déposée sur les parois latérales et dans le fond des guides 23a et 23b. Elle permet de neutraliser les groupes fluorés.

Comme décrit précédemment en relation avec la figure 2, le guide 23a est agencé de sorte qu'il surplombe une partie des évidements 21a et 21b du masque (Figs.3F, 4F). Le guide 23b, visible uniquement sur la vue de dessus de la figure 4F, surplombe une partie d'un autre évidement du masque 20, celui correspondant à la zone à métalliser 21b.

A l'étape F7 (Figs.3G et 4G), une couche 46 de copolymère à blocs est déposée à l'intérieur des guides 23a et 23b, sur les surfaces recouvertes de la couche de greffage. Le copolymère est, de préférence, étalé sur toute la surface du substrat par dépôt à la tournette (« spin-coating »). Puis, le copolymère est assemblé, par exemple par chauffage de la couche de copolymère 46.

Le copolymère à blocs est, de préférence, un copolymère di-bloc contenant du polystyrène (PS) et du polyméthacrylate de méthyle (PMMA). Différentes proportions de PS et de PMMA peuvent être envisagées. A titre d'exemple, avec 30% en poids de PMMA et 70 % en poids de PS, les blocs de PMMA sont, après assemblage, en forme de cylindres 24 contenus dans une matrice de PS.

Dans le cas d'un copolymère à blocs PS-b-PMMA, la couche de greffage est, par exemple, à base d'homo-polystyrène. L'homo-polystyrène garantit, dans l'exemple d'intégration proposé ici, une bonne affinité du copolymère à blocs PS-b-PMMA avec les parois des guides 23a et 23b.

Avantageusement, une couche de copolymère aléatoire PS-r-PMMA peut être également déposée sur le fond des guides 23a et 23b. Cette couche améliore encore l'affinité du copolymère avec le fond des guides, permettant ainsi aux cylindres 24 de PMMA de descendre jusqu'au fond des guides.

A l'étape F8 des figures 3H et 4H, les cylindres de PMMA sont gravés sélectivement par rapport à la matrice de polystyrène, par exemple en plongeant le substrat dans de l'acide acétique concentré à 99% pendant 10 minutes. On obtient alors une pluralité de trous cylindriques 24' dans une couche résiduelle 46' composée uniquement de polystyrène.

Dans ce mode de mise en oeuvre préférentiel, l'élargissement et la fusion des trous cylindriques 24' sont obtenus grâce à plusieurs étapes de gravure successives, de préférence de type plasma RIE.

Tout d'abord, si une couche de greffage en homo-polystyrène a été déposée au fond des guides d'assemblage, celle-ci est gravée par RIE, de préférence au moyen d'un plasma contenant du dioxygène (O₂). Des mélanges gazeux à base d'O₂ comme HBr/O₂, Cl₂/O₂, CO/O₂, SO₂/O₂, N₂/O₂, He/O₂ et CₓH_{y}/O₂ peuvent être utilisés. A titre d'exemple, le plasma est généré à partir d'un mélange de gaz Ar/O₂, sous une pression de 10 mTorr, avec une puissance de 220 W et une tension de polarisation de 200 V. La vitesse de gravure de ce plasma est de l'ordre de 779 À/min.

En gravant ainsi la couche de neutralisation, les trous cylindriques 24' de la couche de polystyrène 46' sont légèrement élargis. De préférence, la quantité de dioxygène dans le mélange de gaz est comprise entre 9 % et 100 % du mélange, et le temps de gravure est compris entre 5 s et 30 s. Dans ces conditions, seulement une partie du polystyrène de la couche 46' est gravée (l'épaisseur de la couche 46' de PS est, après gravure, supérieur ou égale à 10 nm). Il est donc toujours possible de distinguer les trous 24' de la couche 46'.

Les trous 24' sont ensuite transférés dans la couche de nitrure de titane 42 du deuxième niveau de masquage 40, comme cela est représenté sur les figures 3H et 4H. Ce transfert est, de préférence, réalisé au moyen d'une gravure plasma anisotrope (de type RIE par exemple) à travers la couche de polystyrène 46', avec arrêt sur la couche d'oxyde 41 du deuxième niveau de masquage 40. Lorsque la couche 42 est en TiN, le plasma est de préférence généré à l'aide d'un mélange gazeux contenant du dichlore (Cl₂): Cl₂/Ar, Cl₂/He, Cl₂/CₓH_{y}, Cl₂/Ar/CₓH_{y}, Cl₂/CₓF_{y}, Cl₂/Ar/CₓF_{y}, Cl₂/BCL₃... S'il s'agit d'une couche de nitrure 42 en SiN, on choisira une chimie adaptée, par exemple une chimie fluorée.

A titre d'exemple, la couche de TiN 42, dont l'épaisseur est comprise entre 10 nm et 30 nm, est gravée par un plasma Cl₂/Ar/CₓH_{y} généré par un champ RF sous une pression de 15 mTorr, avec une puissance de 500 W et une tension de polarisation de 200 V. La vitesse de gravure du TiN par ce plasma est de l'ordre de 1280 À/min.

Après l'étape F8 du procédé (Figs.3H, 4H), les trous 24' dans la couche 46' de polystyrène et la couche 42 de TiN ne sont pas encore fusionnés, et la dimension critique CDᵥᵢₐ des zones de contact n'est pas atteinte. L'élargissement des trous doit donc être poursuivi.

Pour ce faire, la couche TiN 42 est gravée de façon isotrope et sélective par rapport à l'oxyde 41 et le polystyrène 46'. Cela a pour effet d'élargir les trous 24' qui viennent d'être transférés dans la couche de nitrure 42. Cette étape de gravure isotrope du TiN, appelée aussi « sur-gravure », est de préférence réalisée en utilisant un plasma de Cl₂ uniquement ou BCl₃/Cl₂, sans bombardement (par exemple sous une pression de 8 mTorr, pour une puissance de 400 W et une tension de polarisation nulle, la vitesse de gravure du TiN étant alors de 800 À/min environ).

Ces nouveaux motifs, plus larges, sont à leur tour transférés dans la couche d'oxyde de silicium 41 par gravure anisotrope à travers les couche 42 et 46', puis de nouveau élargis par gravure isotrope de la couche d'oxyde 41 (sélectivement par rapport à la couche d'OPL 39). Ces gravures anisotrope et isotrope de l'oxyde sont, de préférence, réalisée à l'aide d'une chimie fluorée (ex. : CF₄, CₓF_{y}, CHₓF_{y}, SF₆, NF₃, CₓF_{y}/O2, CₓF_{y}/CHₓF_{y}, CₓF_{y}/Ar/CHₓF_{y}, CₓF_{y}/He/CHₓF_{y}...).

A titre d'exemple, la couche d'oxyde 41, dont l'épaisseur est comprise entre 10 nm et 30 nm, est gravée de façon anisotrope par un plasma CF₄/O₂ (7 mtorr, 900 W, 200 V, vitesse de gravure de l'oxyde de 1384 À/min environ), puis de façon isotrope par un plasma CF₄ sans bombardement (5 mtorr, 800 W, 0 V, vitesse de gravure de 256 À/min environ).

Lors de la gravure isotrope de l'oxyde 41 (et dans une moindre mesure lors de la gravure isotrope du TiN), du polystyrène est consommé, car la sur-gravure de l'oxyde 41 n'est pas totalement sélective vis-à-vis du polystyrène de la couche 46'.

Ainsi, dans ce mode de mise en oeuvre préférentiel, l'élargissement des trous dans la couche 46' a lieu en même temps que l'élargissement des trous dans le deuxième niveau de masquage 40, et plus particulièrement dans sa couche d'oxyde 41, jusqu'à l'obtention (dans la couche 46' et le deuxième niveau de masquage 40) d'une tranchée continue 25 ayant une largeur égale à la dimension critique CDᵥᵢₐ souhaitée (cf. Fig.2).

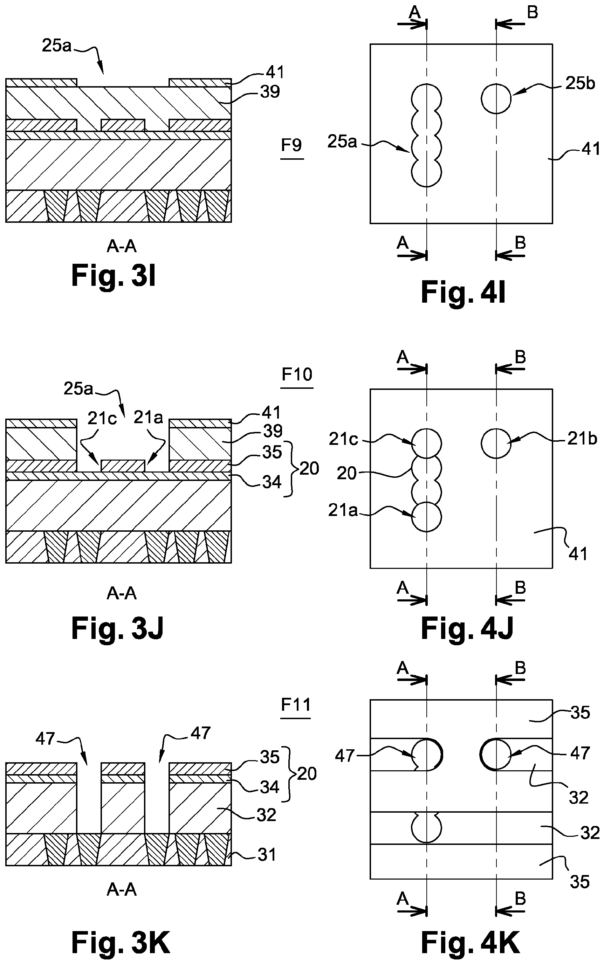

La couche de nitrure 42 et la couche d'oxyde 41 ainsi gravées forment un deuxième masque dur, qui permettra de graver une portion de la couche OPL 39, lors d'une étape ultérieure du procédé représentée aux figures 3J et 4J.

Le fait d'utiliser le deuxième masque 40 permet de contrôler plus facilement l'élargissement des trous et leur fusion en une tranchée continue. Grâce à la bonne sélectivité entre le TiN et le copolymère d'une part, et la faible épaisseur de TiN à graver d'autre part, on peut transférer facilement les motifs du copolymère dans le TiN, même si on a une faible épaisseur de copolymère. Une fois les trous transférés dans la couche de TiN 42, celle-ci suffit à graver l'oxyde 41 sous-jacent. Il n'y a alors plus de contraintes sur l'épaisseur de copolymère. Le masque TiN/oxyde est ensuite suffisant pour graver la couche OPL 39.

Selon l'épaisseur de la couche de copolymère 46', l'épaisseur du masque 40 et la sélectivité des chimies de gravure, on peut envisager d'utiliser un masque 40 ayant une seule couche 41, de préférence en oxyde TEOS.

A l'étape F9 des figures 3I et 4I, on retire la couche OPL 43 et la couche restante de polystyrène 46' du substrat, sélectivement par rapport à l'oxyde 41 et au nitrure 42. Comme cela est représenté, on retire également la couche de nitrure de titane 42. Ce dernier retrait s'effectue sélectivement par rapport au masque d'oxyde 41 et la couche OPL 39 située sous le masque d'oxyde 41, par exemple par gravure plasma avec un mélange gazeux contenant du dichlore (Cl₂).

On peut aussi, selon un autre enchaînement d'étapes, retirer la couche OPL 43 et la couche de copolymère 46' avant de graver l'oxyde 41 (mais après le transfert des motifs dans la couche de nitrure 42). La couche de TiN 42 est alors le seul masque utilisé pour graver l'oxyde 41.

L'étape F10 représentées aux figures 3J (vue de coupe selon A-A) et 4J (vue de dessus) correspond à la gravure de la couche de planarisation 39 à travers le masque dur 41 en oxyde de silicium. Cette gravure est, par exemple, une gravure sèche de type plasma. La gravure débouche sur le premier masque 20, en laissant apparaître une partie des évidements 21a et 21c. La gravure étant sélective par rapport au nitrure de titane et à l'oxyde de silicium, aucune des couches 34 et 35 n'est impactée par la gravure du matériau organique.

Eventuellement, l'étape F10 peut comprendre, à l'instar de la couche de TiN 42 et la couche d'oxyde 41 du masque supérieur, deux étapes de gravure, la première anisotrope et la seconde isotrope. Le matériau de la couche OPL 39 étant carboné, ces gravures sont avantageusement accomplies en utilisant une chimie à base d'O₂, comme pour la gravure du polystyrène. Cette gravure isotrope facultative permet si nécessaire d'élargir encore la tranchée 25a dans la couche d'OPL 39, afin qu'elle englobe totalement les zones de contact. Cette gravure supplémentaire n'est pas nécessaire si l'élargissement voulue est atteint durant la gravure du TiN et de l'oxyde.

A titre d'exemple, la couche de planarisation 39, dont l'épaisseur est comprise entre 50 nm et 300 nm, est gravée de façon anisotrope et isotrope par un plasma HBr/O₂ (5 mtorr, 533 W, 450 V, vitesse de gravure de l'OPL de 3000 À/min environ).

Enfin, en F11 (Figs.3K, 4K), les parties exposées de la couche d'oxyde 34, c'est-à-dire les parties des évidements 21a et 21c dégagées par la gravure du matériau organique 39, sont gravées sélectivement par rapport à la couche de nitrure 35. Les ouvertures dans la couche d'oxyde 34 sont ainsi limitées aux zones qui résultent de la superposition des évidements 21a et 21c d'une part, et de la tranchée 25a d'autre part.

Cette gravure permet également de supprimer la couche d'oxyde 41 située sur la couche OPL 39. Il s'agit, de préférence, d'une gravure anisotrope à l'aide d'une chimie fluorée (CₓF_{y}, CHₓF_{y}, SF₆, NF₃ par exemple).

Puis, après ouverture de la couche d'oxyde 34, des trous de contact 47 sont obtenus en gravant la couche diélectrique 32 à travers le masque 20 (c'est-à-dire de façon sélective par rapport au nitrure et à l'oxyde) jusqu'au niveau d'interconnexion inférieur 31. La couche OPL 39 est avantageusement éliminée au cours de cette seconde gravure de l'étape F11.

Dans le plan de coupe A-A de la figure 3K, les trous de contact 47 dans la couche diélectrique 32 sont traversants. Ils débouchent sur des pistes métalliques du niveau d'interconnexion inférieur 31. Des vias peuvent alors être formés, en remplissant de métal (par exemple du cuivre) les trous de contacts, puis en éliminant le surplus de métal qui déborde des trous (par exemple, par planarisation mécano-chimique, CMP). Avantageusement, une couche barrière limitant la diffusion de métal dans le matériau diélectrique de la couche 32 est déposée dans les trous de contact 47, avant leur remplissage par le métal.

Le procédé de réalisation de motifs décrit ci-dessus peut aussi conduire à la formation des tranchées qui recevront les pistes métalliques du niveau d'interconnexion supérieur. Les empreintes des lignes de métal ont en effet été définies dans le masque 20, à l'étape des figures 3C et 4C. Il s'agit des zones à métalliser 21a à 21c.

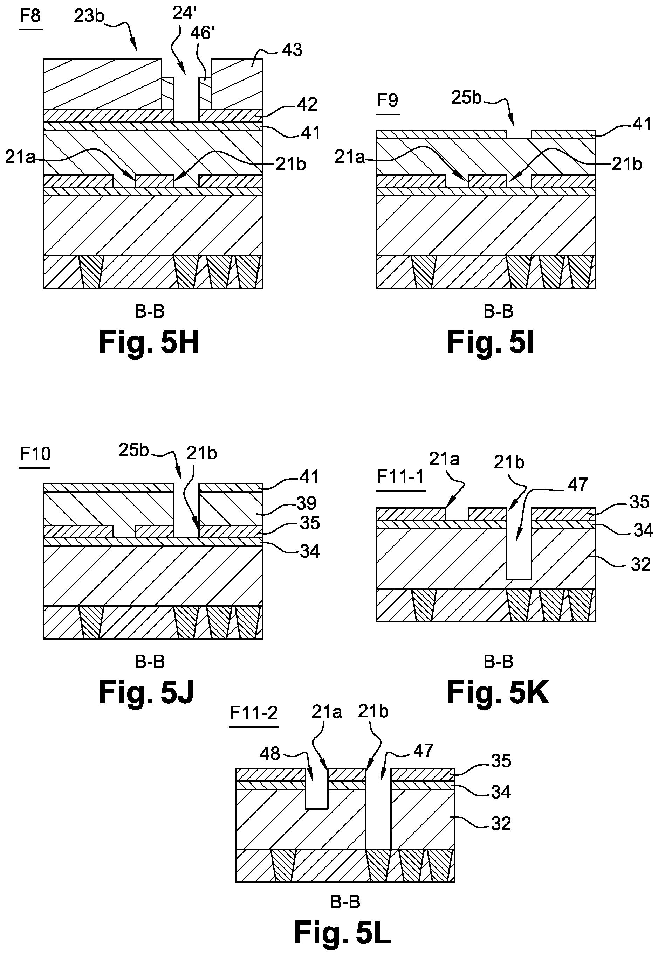

Les figures 5H à 5L reprennent certaines des étapes du procédé (respectivement F8, F9, F10 et F11, cette dernière étant représentée en deux sous-étapes F11-1 et F11-2), pour monter de quelle manière on peut différencier la formation d'un trou de contact (via) de la formation d'une tranchée moins profonde (piste métallique). Alors que les figures 3A à 3K représentaient en coupe selon l'axe A-A des étapes pour former deux trous de contact adjacents (vias), les figures 5H à 5L sont des vues en coupe du substrat selon l'axe B-B de la figure 2, respectivement lors des étapes F8, F9, F10 et F11. Elles montrent la formation d'un trou de contact isolé (zone de contact 22b) et d'une portion de tranchée correspondant à la zone à métalliser 21a (Fig.2).

Vues en coupe selon l'axe B-B, les étapes de formation du guide 23b, d'assemblage et de développement du copolymère à blocs dans le guide 23b (Fig.5H) sont limitées à une zone du substrat qui surplombe une portion seulement de la zone à métalliser 21b (i.e. la zone de contact 22b de la figure 2). Contrairement au cas précédent, le guide d'assemblage 23b ne s'étend pas au-dessus de la zone à métalliser 21a, car aucun via n'est prévu à cet emplacement (cf. Fig.2).

Aux étapes F8 et F9 (Figs.5H-5I), l'unique trou 24' dans la couche de polystyrène 46', résultant de l'élimination de la phase de PMMA, est transféré au sein du second masque bi-couche 41-42 puis élargi, comme décrit précédemment en relation avec les figures 3H et 3I. En regard de la zone à métalliser 21a, la couche d'oxyde 41 est laissée intacte.

Le trou élargi 25b est propagé en F10 (Fig.5J) dans la couche de planarisation 39 à travers la couche d'oxyde 41 du second masque, puis en F11-1 (Fig.5K) dans la couche diélectrique 32 à travers la couche de nitrure 35 du premier masque, après ouverture de la couche d'oxyde 34.

L'ouverture de la couche d'oxyde 34 dans le trou élargi 25b ayant permis simultanément l'élimination du masque d'oxyde 41 supérieur, la couche OPL 39 se trouve exposée et gravée en même temps que la couche diélectrique 32 à l'étape F11-1.

Au moment où le masque de nitrure 35 est libéré, le trou de contact 47 n'est que partiellement formé. La gravure de la couche 32 se poursuit alors, à la fois dans la zone à métalliser 21b pour finaliser le trou traversant 47, mais également dans la zone à métalliser 21a pour former une tranchée 48 moins profonde. Cette deuxième phase F11-2 de la gravure de la couche diélectrique 32 est représentée (en coupe selon B-B) à la figure 5L. La gravure est stoppée lorsque le trou 47 atteint la piste métallique du niveau d'interconnexion inférieur. La gravure de la tranchée 48 ayant commencé en retard par rapport à celle du trou de contact 47, la tranchée 48 ne traverse pas entièrement la couche 32. On peut également jouer sur la sélectivité de gravure entre les différents matériaux pour réaliser cette tranchée moins profonde.

Naturellement, le procédé de réalisation de motifs selon l'invention n'est pas limité au mode de réalisation qui vient d'être décrit en référence aux figures 3 à 5 et de nombreuses variantes peuvent être envisagées.

Par exemple, d'autres matériaux que ceux cités précédemment peuvent être utilisées, notamment pour la couche de copolymère à blocs (PS-b-PDMS, PS-b-PMMA-b-PEO, PS-b-P2VP par exemple), les couches de planarisation (à base de matériau carboné notamment) et les différents niveaux de masque (BN, SiₓN_{y} par exemple). Le nombre de ces niveaux est également susceptible de varier, selon la nature des couches et les techniques de gravure utilisées.

Les guides d'assemblage pourront être définis par chémi-épitaxie, plutôt que par grapho-épitaxie, en greffant sur la surface du substrat une couche ayant des propriétés chimiques différentes selon les régions.

Enfin, dans une variante de mise en oeuvre, les guides d'assemblage peuvent être formés par grapho-épitaxie directement dans une couche de résine déposée sur le deuxième niveau de masquage, plutôt que dans une couche organique de planarisation. Cette résine est alors structurée à l'aide d'un procédé NTD (« Negative Tone Development » en anglais). Elle n'est pas soluble dans le solvant utilisé pour déposer le copolymère à blocs.

## Revendications

1. Procédé de réalisation de motifs (47) à la surface d'un substrat (30) par auto-assemblage de copolymère à blocs, comprenant les étapes suivantes :
- former (F1-F3) à la surface du substrat (30) un premier masque (20) comportant des évidements (21a, 21c), les évidements du masque délimitant à la surface du substrat (30) des zones à métalliser ;
- former (F4-F6) un guide d'assemblage (23a) au-dessus du premier masque (20), de sorte que le guide d'assemblage délimite une surface couvrant deux zones de contact (22a, 22c) et une portion pleine du premier masque (20) disposée entre les deux zones de contact (22a, 22c), les deux zones de contact (22a, 22c) appartenant respectivement à deux zones à métalliser ;
- déposer (F7) sur ladite surface une couche de copolymère à blocs (46) ;
- réorganiser (F7) la couche de copolymère à blocs (46) ;
- éliminer (F8) une des phases de la couche de copolymère à blocs (46) réorganisée, d'où il résulte une pluralité de trous (24') s'étendant dans la couche de copolymère à blocs (46) au-dessus des deux zones de contact (22a, 22c) et de ladite portion pleine du premier masque (20) ;
- élargir (F9) par gravure les trous de la couche de copolymère à blocs, jusqu'à former une tranchée continue (25a) au-dessus des deux zones de contact (22a, 22c) et de ladite portion pleine du premier masque (20) ;
- transférer (F10-F11) à la surface du substrat, au travers des évidements du premier masque (20), des première et deuxième parties de la tranchée continue (25a) situées au-dessus des deux zones de contact (22a, 22c), d'où il résulte lesdits motifs (47), ladite portion pleine du premier masque (20) empêchant le transfert à la surface du substrat d'une troisième partie de la tranchée continue (25a) située au-dessus de ladite portion pleine du premier masque (20).

2. Procédé selon la revendication 1, comprenant en outre les étapes suivantes :
- déposer (F4) une couche de planarisation (39) sur le premier masque (20) et au moins une couche (41) destinée à former un deuxième masque sur la couche de planarisation (39), le guide d'assemblage (23a) et la couche de copolymère à blocs (46) étant formés sur ladite couche (41) destinée à former le deuxième masque ;
- former simultanément ladite tranchée continue (25a) dans la couche de copolymère à blocs (46) et dans le deuxième masque (41) ; et
- transférer (F10) la tranchée continue (25a) du deuxième masque dans la couche de planarisation (39) jusqu'au premier masque (20).

3. Procédé selon la revendication 2, dans lequel le deuxième masque est formé d'un empilement comprenant une couche de nitrure (42) et une couche d'oxyde (41).

4. Procédé selon la revendication 3, dans lequel la formation de la tranchée (25a) dans le deuxième masque comprend successivement une étape de gravure anisotrope de la couche de nitrure (42) à travers la couche de copolymère à blocs (46), une étape de gravure isotrope de la couche de nitrure (42), une étape de gravure anisotrope de la couche d'oxyde (41) à travers la couche de nitrure (42) et une étape de gravure isotrope de la couche d'oxyde (41).

5. Procédé selon la revendication 4, dans lequel l'élargissement des trous (24') de la couche de copolymère à blocs (46) se produit lors des étapes de gravure isotrope de la couche de nitrure (42) et de la couche d'oxyde (41).

6. Procédé selon l'une quelconque des revendications 1 à 5, dans lequel le guide d'assemblage (23a) est rectiligne et arrangé de sorte que les deux zones de contact (22a, 22c) occupent des extrémités de la surface délimitée par le guide d'assemblage (23a).

7. Procédé selon l'une quelconque des revendications 1 à 6, dans lequel le guide d'assemblage (23a) est formé par grapho-épitaxie, le procédé comprenant en outre une étape de dépôt d'une couche de greffage sur des parois latérales et au fond du guide d'assemblage.

8. Procédé selon la revendication 7, dans lequel le copolymère à blocs (46) contient du polystyrène et du polyméthacrylate de méthyle et dans lequel la couche de greffage est à base d'homo-polystyrène.

9. Procédé selon la revendication 8, comprenant, immédiatement après l'élimination (F8) d'une des phases de la couche de copolymère à blocs (46) réorganisée, une étape de gravure de la couche de greffage par un plasma contenant du dioxygène.

10. Procédé selon l'une quelconque des revendications 1 à 9, dans lequel le substrat (30) comporte un niveau de connexion électrique (31) et une couche en un matériau diélectrique (32) recouvrant le niveau de connexion électrique et dans laquelle sont formés lesdits motifs (47).

11. Procédé selon la revendication 10, dans lequel les motifs à la surface du substrat (30) sont des trous d'interconnexion (47) traversant la couche en matériau diélectrique (32) jusqu'au niveau de connexion électrique (31).

## Patentansprüche

1. Realisierungsverfahren von Mustern (47) an der Oberfläche eines Substrats (30) per Zusammenbau von Blockpolymeren, umfassend die folgenden Schritte:
- Bilden (F1 - F3) einer Ausnehmungen (21a, 21c) umfassenden ersten Maske (20) an der Oberfläche des Substrats (30), wobei die Ausnehmungen der Maske zu metallisierende Bereiche an der Oberfläche des Substrats (30) begrenzen;
- Bilden (F4 - F6) einer Zusammenbauführung (23a) oberhalb der ersten Maske (20) derart, dass die Zusammenbauführung eine Oberfläche begrenzt, die zwei Kontaktbereiche (22a, 22c) und einen zwischen den zwei Kontaktbereichen (22a, 22c) angeordneten massiven Abschnitt der ersten Maske (20) begrenzt, wobei die zwei Kontaktbereiche (22a, 22c) jeweils zu zwei zu metallisierenden Bereichen gehören;
- Aufbringen (F7) einer Schicht aus Blockpolymeren (46) auf der genannten Oberfläche;
- Reorganisieren (F7) der Schicht aus Blockpolymeren (46);
- Entfernen (F8) einer der Phasen der reorganisierten Schicht aus Blockpolymeren (46), aus der eine sich in der Schicht aus Blockpolymeren (46) oberhalb der zwei Kontaktbereiche (22a, 22c) und dem genannten massiven Abschnitt der ersten Maske (20) erstreckenden Vielzahl von Löchern (24') resultiert;
- Erweitern der Löcher der Schicht aus Blockpolymeren per Gravur (F9), bis ein kontinuierlicher Graben (25a) oberhalb der zwei Kontaktbereiche (22a, 22c) und dem genannten massiven Abschnitt der ersten Maske (20) gebildet wird;
- Übertragen (F10 - F11) des ersten und zweiten Teils des kontinuierlichen Grabens (25a) oberhalb der zwei Kontaktbereiche (22a, 22c) durch die Ausnehmungen der ersten Maske (20) auf die Oberfläche des Substrats, woraus die genannten Muster (47) resultieren, wobei der genannte massive Abschnitt der ersten Maske (20) die Übertragung eines dritten Teils des kontinuierlichen Grabens (25a) oberhalb des genannten massiven Abschnitts der ersten Maske (20) auf die Oberfläche des Substrats verhindert wird.

2. Verfahren gemäß Anspruch 1, umfassend darüber hinaus die folgenden Schritte:
- Aufbringen (F4) einer Planartechnikschicht (39) auf die erste Maske (20) und wenigstens eine zur Bildung einer zweiten Maske auf der Planartechnikschicht (39) bestimmte Schicht (41), wobei die Zusammenbauführung (23a) und die Schicht aus Blockpolymeren (46) auf der genannten, zur Bildung der zweiten Maske bestimmten Schicht (41) gebildet sind,
- gleichzeitiges Bilden des genannten kontinuierlichen Grabens (25a) in der Schicht aus Blockpolymeren (46) und in der zweiten Maske (41); und
- Übertragen (F10) des kontinuierlichen Grabens (25a) der zweiten Maske in die Planartechnikschicht (39) bis zur ersten Maske (20).

3. Verfahren gemäß Anspruch 2, bei dem die zweite Maske aus einer eine Nitridschicht (42) und eine Oxidschicht (41) umfassenden Stapelung gebildet ist.

4. Verfahren gemäß Anspruch 3, bei dem die Bildung des Grabens (25a) in der zweiten Maske sukzessive einen anisotropen Gravurschritt der Nitridschicht (42) durch die Schicht aus Blockpolymeren (46), einen isotropen Gravurschritt der Nitridschicht (42), einen anisotropen Gravurschritt der Oxidschicht (41) durch die Nitridschicht (42) und einen isotropen Gravurschritt der Oxidschicht (41) umfasst.

5. Verfahren gemäß Anspruch 4, bei dem die Erweiterung der Löcher (24') der Schicht aus Blockpolymeren (46) bei den isotropen Gravurschritten der Nitridschicht (42) und der Oxidschicht (41) auftritt.

6. Verfahren gemäß irgendeinem der Ansprüche 1 bis 5, bei dem die Zusammenbauführung (23a) geradlinig und derart angeordnet ist, dass die zwei Kontaktbereiche (22a, 22c) Enden der von der Zusammenbauführung (23a) begrenzten Oberfläche belegen.

7. Verfahren gemäß irgendeinem der Ansprüche 1 bis 6, bei dem die Zusammenbauführung (23a) per Gravur-Epitaxie gebildet ist, wobei das Verfahren darüber hinaus einen Aufbringungsschritt einer Pfropfschicht auf den lateralen Wänden und am Boden der Zusammenbauführung umfasst.

8. Verfahren gemäß Anspruch 7, bei dem das Blockpolymer (46) Polystyrol und Methyl-Polymethacrylat enthält und bei dem die Pfropfschicht auf Homo-Polystyrolbasis ist.

9. Verfahren gemäß Anspruch 8, umfassend unmittelbar nach der Entfernung (F8) einer der Phasen der reorganisierten Schicht aus Blockpolymeren (46) einen Gravurschritt der Pfropfschicht durch ein Dioxigen enthaltendes Plasma.

10. Verfahren gemäß irgendeinem der Ansprüche 1 bis 9, bei dem das Substrat (30) ein elektrisches Anschlussniveau (31) und eine Schicht aus einem dielektrischen Material (32) umfasst, das das elektrische Anschlussniveau abdeckt und in dem die genannten Muster (47) geformt sind.

11. Verfahren gemäß Anspruch 10, bei dem die Muster an der Oberfläche des Substrats (30) Verbundlöcher (47) sind, die die Schicht aus dielektrischem Material (32) bis zum elektrischen Anschlussniveau (31) durchqueren.

## Claims

1. Method for making patterns (47) on the surface of a substrate (30) by self-assembly of block copolymer, comprising the following steps:
- forming (F1-F3) on the surface of the substrate (30) a first mask (20) comprising recesses (21a, 21c), the recesses of the mask delimiting on the surface of the substrate areas to be metallised;
- forming (F4-F6) an assembly guide (23a) above the first mask (20), such that the assembly guide delimits a surface covering two contact areas (22a, 22c) and a solid portion of the first mask (20) arranged between the two contact areas (22a, 22c), the two contact areas (22a, 22c) belonging respectively to two areas to be metallised;
- depositing (F7) on said surface a block copolymer layer (46);
- reorganising (F7) the block copolymer layer (46);
- eliminating (F8) one of the phases of the reorganised block copolymer layer (46), resulting in a plurality of holes (24') extending into the block copolymer layer (46) above the two contact areas (22a, 22c) and said solid portion of the first mask (20);
- widening (F9) by etching the holes of the block copolymer layer, until a continuous trench (25a) is formed above the two contact areas (22a, 22c) and said solid portion of the first mask (20);
- transferring (F10-F11) to the surface of the substrate, through the recesses of the first mask (20), first and second parts of the continuous trench (25a) located above the two contact areas (22a, 22c), thus resulting in said patterns (47), said solid portion of the first mask (20) preventing transfer to the surface of the substrate of a third part of the continuous trench (25a) located above said solid portion of the first mask (20).

2. Method according to claim 1, further comprising the following steps:
- depositing (F4) a planarization layer (39) on the first mask (20) and at least one layer (41) intended to form a second mask on the planarization layer (39), the assembly guide (23a) and the block copolymer layer (46) being formed on said layer (41) intended to form the second mask;
- forming simultaneously said continuous trench (25a) in the block copolymer layer (46) and in the second mask (41); and
- transferring (F10) the continuous trench (25a) of the second mask into the planarization layer (39) up to the first mask (20).

3. Method according to claim 2, wherein the second mask is formed of a stack comprising a nitride layer (42) and an oxide layer (41).

4. Method according to claim 3, wherein the formation of the trench (25a) in the second mask successively comprises a step of anisotropic etching of the nitride layer (42) through the block copolymer layer (46), a step of isotropic etching of the nitride layer (42), a step of anisotropic etching of the oxide layer (41) through the nitride layer (42) and a step of isotropic etching of the oxide layer (41).

5. Method according to claim 4, wherein widening of the holes (24') of the block copolymer layer (46) takes place during steps of isotropic etching of the nitride layer (42) and of the oxide layer (41).

6. Method according to any one of claims 1 to 5, wherein the assembly guide (23a) is rectilinear and arranged such that the two contact areas (22a, 22c) occupy the ends of the surface delimited by the assembly guide (23a).

7. Method according to any one of claims 1 to 6, wherein the assembly guide (23a) is formed by grapho-epitaxy, the method further comprising a step of depositing a grafting layer on the lateral walls and at the bottom of the assembly guide.

8. Method according to claim 7, wherein the block copolymer (46) contains polystyrene and polymethyl methacrylate and wherein the grafting layer is based on homo-polystyrene.

9. Method according to claim 8, comprising, immediately after the elimination (F8) of one of the phases of the reorganised block copolymer layer (46), a step of etching the grafting layer by a plasma containing oxygen.

10. Method according to any one of claims 1 to 9, wherein the substrate (30) comprises an electrical connection level (31) and a dielectric material layer (32) covering the electrical connection level and in which are formed said patterns (47).

11. Method according to claim 10, wherein the patterns on the surface of the substrate (30) are interconnection holes (47) traversing the dielectric material layer (32) up to the electrical connection level (31).
